# EUROPEAN PATENT APPLICATION

(11) **EP 2 784 520 A2**
(43) Date of publication of application: **01.10.2014**
(21) Application number: 14161955.1
(22) Date of filing: 27.03.2014
(51) Int. Cl.: G01R 13/02

(54) **Apparatus and method for displaying waveforms**

(30) Priority: 27.03.2013 US 201313851836
(71) Applicant: Tektronix, Inc., Beaverton, Oregon 97077-0001 (US)
(72) Inventor: Alley, James, Beaverton, OR Oregon 97077-0001 (US); Letts, Peter, Beaverton, OR Oregon 97077-0001 (US)
(74) Representative: Clarke, Jeffrey David

(57) **Abstract**

An apparatus can include a digitizer (302) configured to digitize input data into a plurality of digitized signals, a rasterizer (306) configured to generate a plurality of raster images from the plurality of digitized signals, the rasterizer including a subtractor (310) configured to decrement a pixel intensity counter, a processor (312) configured to manipulate the raster images based on the pixel intensity counter, and a display device (314) configured to display the raster images.

## Description

### Technical Field

The present disclosure relates generally to test and measurement apparatuses, such as oscilloscopes. In particular, oscilloscopes capable of displaying digitized waveforms with a modified persistence decay algorithm are described.

### Background

Known oscilloscopes are not entirely satisfactory for the range of applications in which they are employed. For example, existing oscilloscopes are incapable of displaying anomalous or infrequent waveforms with sufficient intensity and for a sufficient period of time, thus denying the ability of a user to adequately view the waveforms before they dissipate from being displayed. In addition, conventional oscilloscopes having modifiable persistence decay algorithms fail to allow an anomalous waveform to be displayed for a predetermined period of time as defined by the user.

Examples of references relevant to addressing these problems can be found in the following U.S. Patent references: 4,504,827; 5,283,596; and 6,333,732. However, each of these references suffers from one or more of the following disadvantages: anomalous waveforms decay away too quickly and aren't displayed in a discernible manner for the user to perceive them.

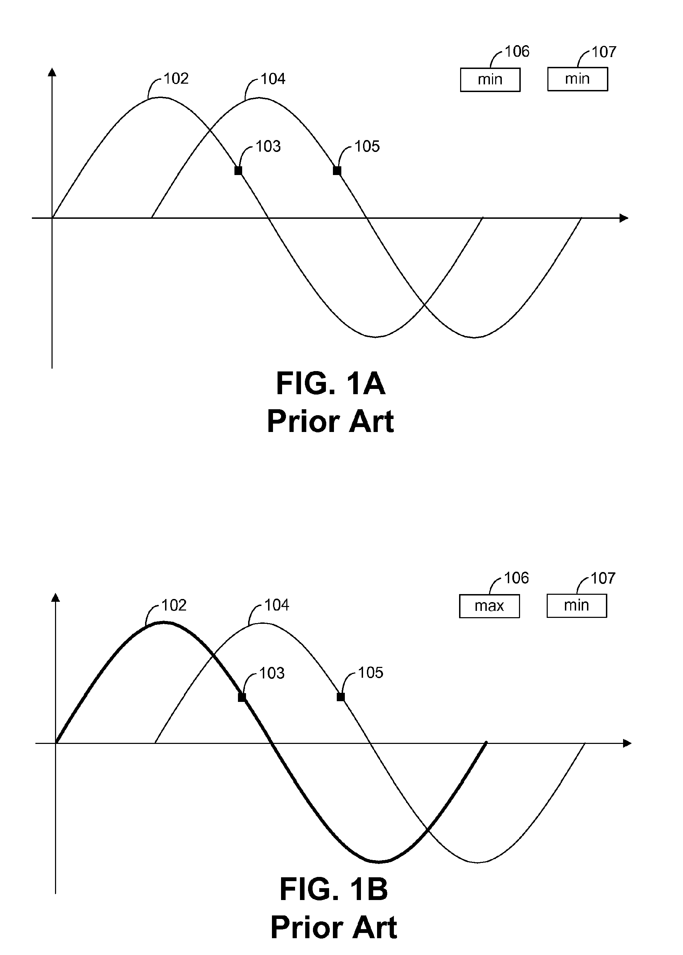

One example of how existing oscilloscopes display waveforms can be seen in Figs. 1A and 1B. In Fig. 1A, a waveform that occurs frequently 102 and a waveform that is significantly different from the frequently-occurring waveform 104 are shown in a very early stage of rasterization. Specifically, the pixel intensities 106 and 107 of pixels of both waveforms, 103 and 105 respectively, are illustrated as having low or minimum intensity upon initial rasterization. It should be noted that the pixel "blocks" 103 and 105 represent a single pixel along each waveform 102 and 104, and each waveform actually contains many pixels represented on the screen by a 32-bit value.

Turning attention to Fig. 1B, at some point in time after initial rasterization occurs, a frequently-occurring waveform 102 will be drawn with pixels 103 that have much greater intensity as evidenced by the maximum value 106 stored in the pixel intensity counter. In contrast, a waveform 104 that is significantly different from the frequently-occurring waveform 102 will be dimly lit as its pixel intensity value 107 will be at a minimum value because of the rarity in which that waveform is rasterized and then displayed.

Conventional oscilloscopes as described above do not allow a waveform 104 that is significantly different from a frequently-occurring waveform 102 to appear with more intensity and longer duration. Indeed, the "rare" waveform 104 of Fig. 1B will appear dim in comparison to waveform 102 and have a faster decay rate. This faster decay rate prevents a user from being able to view the "rare" waveform 104 for longer periods of time.

As the reader can appreciate, there exists a need for oscilloscopes that improve upon and advance the design of known oscilloscopes. Examples of new and useful oscilloscopes relevant to the needs existing in the field are discussed below.

### Summary

An embodiment of the disclosed technology includes an oscilloscope for displaying a waveform including a digitizer to digitize input data into a plurality of digitized signals, a rasterizer configured to generate a plurality of raster images from the digitized signals, the rasterizer further having a subtractor configured to decrement a pixel intensity counter, a processor configured to manipulate the raster images based on the pixel intensity counter, and a display device configured to display the raster images.

Another embodiment of the disclosed technology includes a method of displaying a waveform in an oscilloscope. The method includes acquiring input data corresponding to the waveform, decrementing each of a plurality of pixel intensity based on a first rate of decay, and displaying the waveform based on the plurality of pixel intensity counters.

Yet another embodiment of the disclosed technology includes a method of displaying multiple waveforms in an oscilloscope. The method includes acquiring input data corresponding to a first waveform and a second waveform, where the first waveform is a frequently-occurring waveform and the second waveform is significantly different from the first waveform, decrementing each of a plurality of pixel intensity counters based on a first rate of decay corresponding to the first waveform or a second rate of decay corresponding to the second waveform, and displaying the first and second waveforms based at least in part on values of the plurality of the pixel intensity counters.

### Brief Description of the Drawings

Fig. 1A is a diagram illustrating prior art waveforms where both waveforms have the same pixel intensity.
Fig. 1B is a diagram illustrating prior art waveforms where one waveform has brighter pixel intensity than the other waveform.
Fig. 2A is a signal diagram of a first example of a plurality of waveforms being displayed on an oscilloscope and having the same pixel intensity.
Fig. 2B is a signal diagram of the plurality of waveforms being displayed on the oscilloscope and having different pixel intensities.
Fig. 3 is a block diagram of an oscilloscope for displaying the waveforms shown in Figs. 2A and 2B.
Fig. 4 is a block diagram of a first embodiment of a rasterizer of the oscilloscope shown in Fig. 3.
Fig. 5 is a block diagram of a second embodiment of a rasterizer of the oscilloscope shown in Fig. 3.
Fig. 6 is flowchart of a method of displaying a plurality of waveforms according to an embodiment of the disclosed technology.

### Detailed Description

The disclosed oscilloscopes will become better understood through review of the following detailed description in conjunction with the figures. The detailed description and figures provide examples of the various inventions described herein. Those skilled in the art will understand that the disclosed examples may be varied, modified, and altered without departing from the scope of the inventions described herein. Many variations are contemplated for different applications and design considerations; however, for the sake of brevity, each and every contemplated variation is not individually described in the following detailed description.

Throughout the following detailed description, examples of various oscilloscopes are provided. Related features in the examples may be identical, similar, or dissimilar in different examples. For the sake of brevity, related features will not be redundantly explained in each example. Instead, the use of related feature names will cue the reader that the feature with a related feature name may be similar to the related feature in an example explained previously. Features specific to a given example will be described in that particular example. The reader should understand that a given feature need not be the same or similar to the specific portrayal of a related feature in any given figure or example.

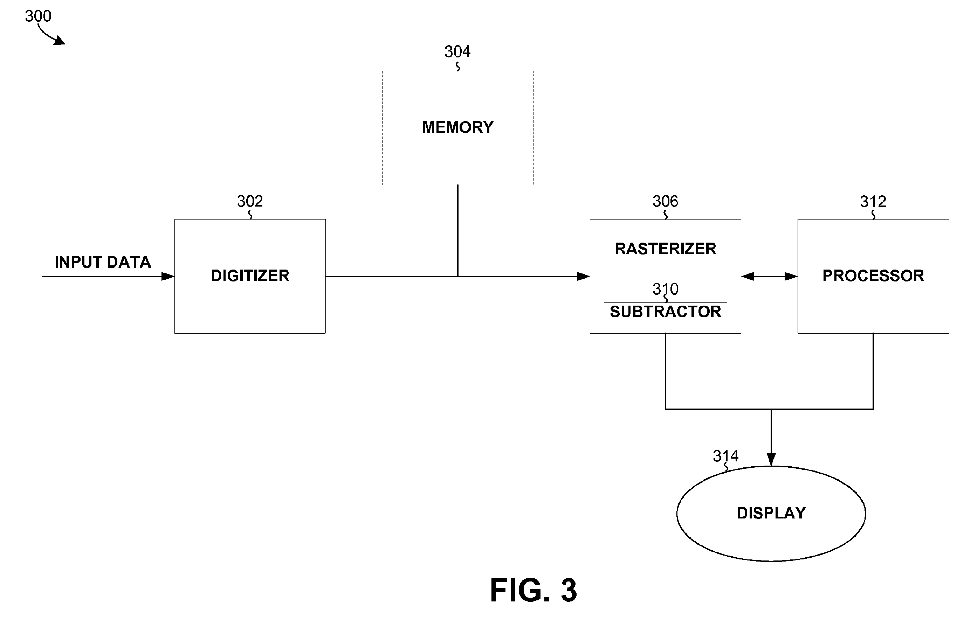

With reference to Fig. 3, a first example of an oscilloscope 300 will now be described. Oscilloscope 300 includes a digitizer 302, a memory 304, a rasterizer 306, a processor 312 and a display device 314. Rasterizer 306 further includes a subtractor unit 310. Oscilloscope 300 functions to display less frequently occurring waveforms with increased brightness and persistence by modifying the persistence decay algorithm. Additionally, oscilloscope 300 can be used to modify the decay rates of multiple waveforms as selected by a user.

With continuing reference to Fig. 3, digitizer 302 acquires input data and transforms that data into a digital representation. For example, digitizer 302 may include a successive approximation analog-to-digital converter (ADC) operating in a real-time sampling mode, sampling as often as possible. Alternatively, digitizer 302 may include a direct conversion ADC operating in an equivalent-time sampling mode, sampling at a determined time period after a triggering event.

Memory 304 is shown in Fig. 3 as being located between digitizer 302 and rasterizer 306; however, such memory storage is not required. For example, digitizer 302 may send digitized signals directly to rasterizer 306 rather than through memory 304.

Processor 312 may communicate directly or indirectly with rasterizer 306. For example, a data bus (not shown) may link processor 312 and rasterizer 306. In addition, processor 312 may communicate with rasterizer 306 through a common memory (not shown). However, common memory may be memory 304 itself or another memory separate from memory 304.

During general operation, the digitized signal is rasterized in rasterizer 306 into a raster image (not shown) to be displayed as a two dimensional (m x n) array of pixels on display 314. A raster image (not shown) is formed of multiple pixels (not shown). Each pixel may be arranged in an m x n array of rows and columns. For example, a rasterizer plane (not shown) is typically 512 x 1024 bytes, where each pixel is made up of a total of 32-bits, 6-bits for pixel information and a 26-bit counter.

Rasterizer 306 further includes a subtractor 310 that is used to decrement the 26-bit counters of each pixel in the raster plane for "rare" waveforms. Generally speaking, the 26-bit pixel intensity counter will start at a count of 2^{N-1} and incrementally subtract away from that initial value based on the frequency of the pixel hit. For example, a "rare" waveform normally receives less pixel hits than a frequently-occurring waveform that receives more pixel hits. However, "rare" events, or waveforms significantly differing from frequently-occurring waveforms would have greater pixel intensity values than frequently-occurring waveforms, thus increasing their pixel brightness and allowing the "rare" waveform to stay on display 314 longer due to the extra time it would take to decrement away from such a large 2^{N-1} number.

Conversely, frequently-occurring waveforms would have much lower pixel intensity values and would decay away from their respective 2^{N-1} counters at a much faster rate, thus causing them to be dimly lit when compared to a "rare" waveform.

Additionally, rasterizer 306 is able to modify the persistence decay algorithm in order to apply different decay rates to the displayed waveforms. Rasterizer 306 records the minimum pixel count and the maximum pixel count in the entire rasterizer image. Then, when the pixel intensity counts are converted to the digitized display signal, these counts are copied and decayed so that the rasterization process can continue in parallel with the on-going conversion of the display intensities.

Rasterizer 306 further employs a decay process that uses a range from the minimum count (non-zero) to the maximum count and divides this range into a set of contiguous sub-ranges and applies a different decay algorithm to the pixel counts in each sub-range. Thus, rasterizer 306 may apply different persistence decay algorithms to large and small pixel intensity counts.

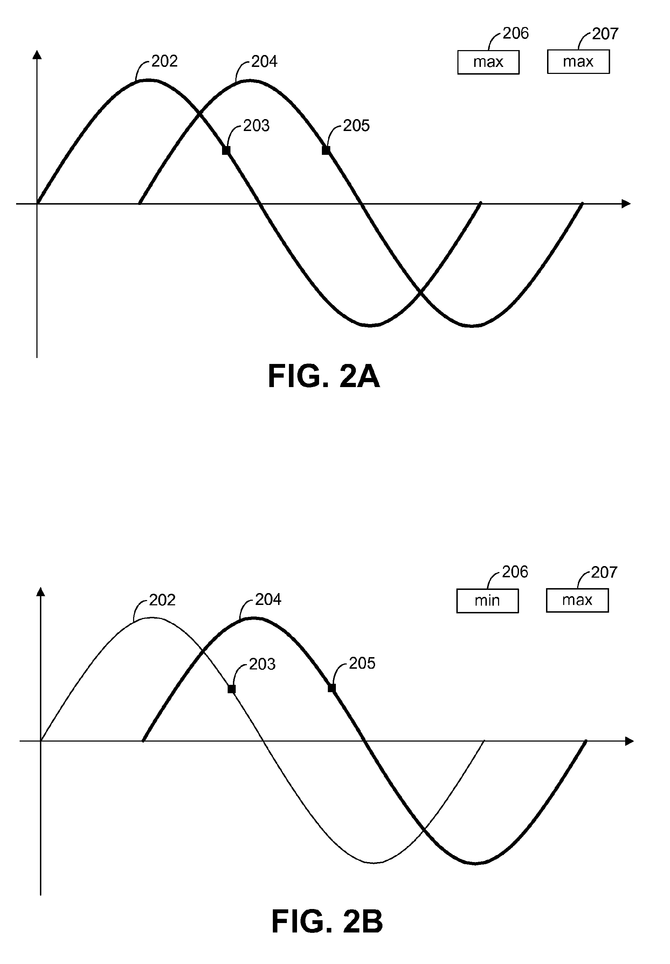

Turning attention to Figs. 2A and 2B, these figures illustrate two data inputs that have been digitized by digitizer 302, rasterized by rasterizer 306, and displayed on display device 314. Fig. 2A specifically illustrates that a frequently-occurring waveform 202 and a waveform 204 differing significantly from waveform 202, or a "rare" waveform are at maximum intensity because their pixel intensity counters, 206 and 207 respectively, have an initial maximum pixel intensity value. Thus, all pixels of waveforms 202 and 204 are brightest at this initial stage. As mentioned earlier, the reader can appreciate that pixels 203 and 205 represent but one of thousands of pixels in each of waveforms 202 and 204.

Fig. 2B illustrates the two waveforms of Fig. 2A after some time has elapsed. Frequently-occurring waveform 202 would have a minimum pixel intensity value 206 for each of its pixels 203. However, "rare" waveform 204 would have a maximum pixel intensity value 207 for each of its pixels 205, making the waveform brighter on display device 314. Further, the persistence decay algorithm would be modified so that the decay rate of waveform 204 would be longer than waveform 202, thus displaying waveform 204 for a longer period of time.

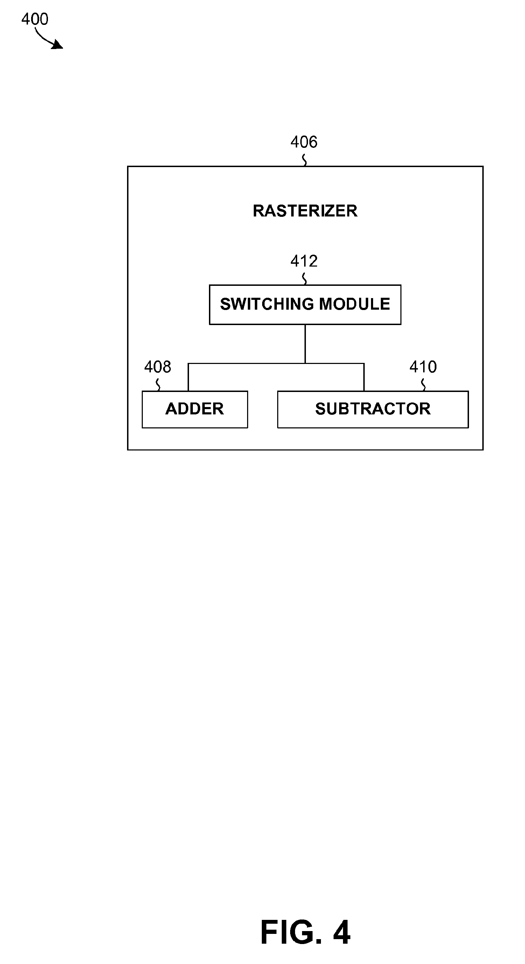

Turning attention to Fig. 4, a second example of an oscilloscope 400 will now be described. Oscilloscope 400 includes many similar or identical features to oscilloscope 300. Thus, for the sake of brevity, each feature of oscilloscope 400 will not be redundantly explained. Rather, key distinctions between oscilloscope 400 and oscilloscope 300 will be described in detail and the reader should reference the discussion above for features substantially similar between the two oscilloscopes.

As can be seen in Fig. 4, oscilloscope 400 includes a digitizer 402 (not shown), a memory 404 (not shown), a rasterizer 406, a processor 412 (not shown), and a display device 414 (not shown). In this example, oscilloscope 400 further includes an adder 408 and a switching module 412, both of which are located internally to rasterizer 406, whereas rasterizer 306 of oscilloscope 300 did not include either of those elements.

Adder 408 functions to operate the same as adders of conventional oscilloscopes. The pixel intensity counter of adder 408 will have an initial value of zero and will increment by a fixed value for each acquisition that falls within that pixel location. Switching module 412 functions to allow oscilloscope 400 to employ either adder 408 or subtractor 410.

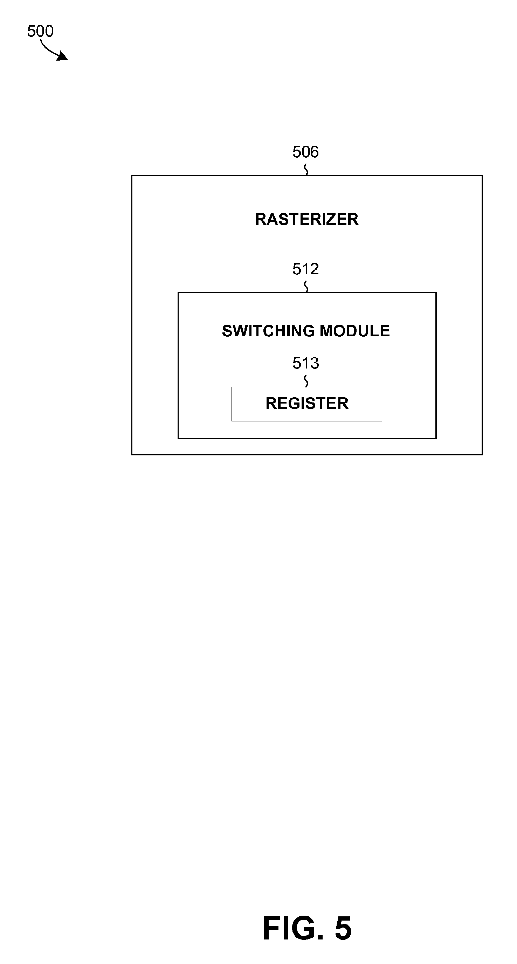

Turning attention to Fig. 5, a third example of an oscilloscope 500 will now be described. Oscilloscope 500 includes many similar or identical features to oscilloscope 400. Thus, for the sake of brevity, each feature of oscilloscope 400 will not be redundantly explained. Rather, key distinctions between oscilloscope 500 and oscilloscope 400 will be described in detail and the reader should reference the discussion above for features substantially similar between the two oscilloscopes.

As can be seen in Fig. 5, oscilloscope 500 includes a digitizer 502 (not shown), a memory 504 (not shown), a rasterizer 506, a processor 512 (not shown), and a display device 514 (not shown). In this example, oscilloscope 500 further includes a register 513, whereas rasterizer 406 of oscilloscope 400 did not include this element. Register 513 functions to store pixel intensity values of the rasterized images.

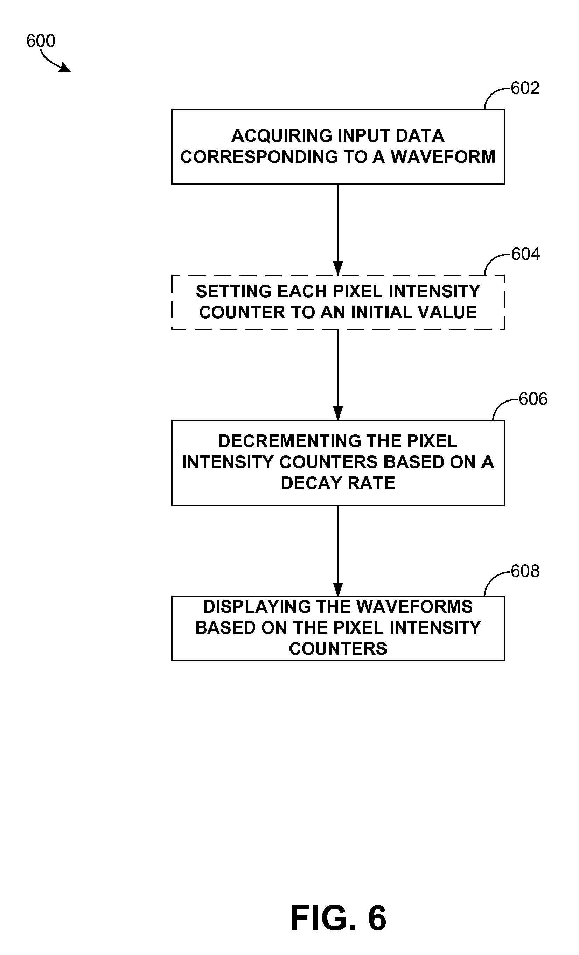

Turning attention to Fig. 6, a method 600 of displaying a waveform will now be described. Method 600 includes acquiring input data corresponding to a waveform 602, setting each pixel intensity counter to an initial value 604, decrementing the pixel intensity counters based on a decay rate 606, and displaying the waveforms based on the pixel intensity counters 608.

With continuing reference to Fig. 6, block 602 illustrates the step of acquiring an input signal that is digitized for later use by the rasterizer. Additionally, the digitized input may be stored into a memory for later manipulation by the rasterizer or processor.

Next, block 604 illustrates the step of setting each pixel intensity counter to an initial value of 2^{N-1}. This initial value is set when pixel information pertaining to the waveforms is acquired. In this example, and as previously described above, the initial pixel intensity values for the frequently-occurring waveform 202 and the "rare" waveform 204 (see Fig. 2A) will be at a maximum value. However, after a brief period of time, the pixel intensity value for frequently-occurring waveform 202 will be a minimum value and "rare" waveform 204 will be at a maximum value (see Fig. 2B).

In block 606, the step of decrementing the pixel intensity counters is illustrated. The pixel intensity counter of the "rare" waveform 204 (see Fig. 2B) will have an initial maximum value of 2^{N-1}. For each subsequent pixel that is acquired in this waveform, the 26-bit counter will be decremented at a much slower decay rate than frequently-occurring waveform 202. This slower decay rate will allow the "rare" waveform 204 to remain displayed for a longer period of time than frequently-occurring waveform 202. Once the counter has decremented down to zero, it will automatically reset back to the maximum value of 2^{N-1} value when the next pixel for the waveform has been acquired and the decrementing process begins again.

Regarding the frequently-occurring waveform 202, its 26-bit counter will also decrement after each pixel acquisition; however, the decay rate will be much greater. In other words, these waveforms will decay away very rapidly making their pixels much less prominent than the pixels for the "rare" waveform 204.

Additionally or alternatively, both frequently-occurring waveform 202 and "rare" waveform 204 may be set to several different rates of decay. For example, as previously mentioned above, the decay rate for "rare" waveforms will be lower so that these waveforms are displayed for longer periods of time before decaying away from view. In contrast, the decay rate for frequently-occurring waveforms 202 will typically be much greater than the decay rate for "rare" waveforms as the goal is to make the "rare" waveforms 204 more prominent by causing the frequently-occurring waveforms 202 to decay very rapidly.

Still referring to Fig. 6, block 608 illustrates the step of displaying the frequently-occurring waveform 202 and the "rare" waveform 204 on a display device. This is generally done once rasterizer 306 has rasterized the image and it is ready to be drawn.

The disclosure above encompasses multiple distinct inventions with independent utility. While each of these inventions has been disclosed in a particular form, the specific embodiments disclosed and illustrated above are not to be considered in a limiting sense as numerous variations are possible. The subject matter of the inventions includes all novel and non-obvious combinations and subcombinations of the various elements, features, functions and/or properties disclosed above and inherent to those skilled in the art pertaining to such inventions. Where the disclosure or subsequently filed claims recite "a" element, "a first" element, or any such equivalent term, the disclosure or claims should be understood to incorporate one or more such elements, neither requiring nor excluding two or more such elements.

Applicant reserves the right to submit claims directed to combinations and subcombinations of the disclosed inventions that are believed to be novel and non-obvious. Inventions embodied in other combinations and subcombinations of features, functions, elements and/or properties may be claimed through amendment of those claims or presentation of new claims in the present application or in a related application. Such amended or new claims, whether they are directed to the same invention or a different invention and whether they are different, broader, narrower or equal in scope to the original claims, are to be considered within the subject matter of the inventions described herein.

The following section of the description consists of numbered paragraphs simply providing statements of the invention already described herein. The numbered paragraphs in this section are not claims. The claims are set forth below in the later section headed "claims".
1. An oscilloscope comprising: a digitizer configured to digitize input data into a plurality of digitized signals; a rasterizer configured to generate a plurality of raster images from the plurality of digitized signals, the rasterizer having a subtractor configured to decrement a pixel intensity counter; a processor configured to manipulate the raster images based on the pixel intensity counter; and a display device configured to display the raster images.
2. The oscilloscope of 1, further including a memory module configured to store the digitized signal.
3. The oscilloscope of 1 or 2, the rasterizer further including an adder configured to increment the pixel intensity counter.
4. The oscilloscope of 3, further including a switching module configured to allow back and forth switching of the rasterizer between a first mode using the subtractor and a second mode using the adder.
5. The oscilloscope of 4, wherein the switching module includes a register.
6. The oscilloscope of 4 or 5, wherein the switching module resides inside the rasterizer.
7. A method for displaying a waveform in an oscilloscope, the method comprising:
   acquiring input data corresponding to the waveform; decrementing each of a plurality of pixel intensity counters based on a first rate of decay; and displaying the waveform based on the plurality of pixel intensity counters.
8. The method of 7, further comprising setting each of the pixel intensity counters to an initial pixel intensity value that is greater than zero and determined by 2^{N-1}, where N represents a number of bits in each pixel intensity counter.
9. The method of 8, wherein N has a value of 26.
10. The method of 7 to 9, further comprising resetting each of the pixel intensity counters to the initial value of 2^{N-1} responsive to the pixel intensity counters reaching a value of zero.
11. The method of 7 to 10, further comprising determining the first rate of decay based on a minimum pixel count and a maximum pixel count in at least one image of the waveform.
12. The method of 7 to 11, wherein the waveform differs significantly from a frequently-occurring waveform.
13. The method of 7 to 12, wherein the waveform is a frequently-occurring waveform.
14. The method of 7 to 13, wherein the oscilloscope is a digital phosphorous oscilloscope.
15. The method of 7 to 14, wherein decrementing each of the pixel intensity counters is based on a second rate of decay or a third rate of decay.
16. A method for displaying a plurality of waveforms in an oscilloscope, the method comprising: acquiring input data corresponding to a first waveform and a second waveform, wherein the first waveform is a frequently-occurring waveform and the second waveform is significantly different from the first waveform; decrementing each of a plurality of pixel intensity counters based on a first rate of decay corresponding to the first waveform or a second rate of decay corresponding to the second waveform; and displaying the first and second waveforms based at least in part on values of the plurality of pixel intensity counters.
17. The method of 16, further comprising setting the pixel intensity counters to initial pixel intensity values that are greater than zero and determined by 2^{N-1}, where N represents a number of bits in each pixel intensity counter.
18. The method of 16 or 17, further comprising resetting each of the pixel intensity counters to the initial value of 2^{N-1} responsive to the pixel intensity counters reaching a value of zero.
19. The method of 18, wherein N has a value of 26.
20. The method of 16 to 19, further comprising determining the first rate of decay corresponding to the first waveform and the second rate of decay corresponding to the second waveform based on a minimum pixel count and a maximum pixel count respectively, in a first image corresponding to the first waveform and in a second image corresponding to the second waveform.

## Claims

1. An oscilloscope comprising;
a digitizer configured to digitize input data into a plurality of digitized signals;
a rasterizer configured to generate a plurality of raster images from the plurality of digitized signals, the rasterizer having a subtractor configured to decrement a pixel intensity counter;
a processor configured to manipulate the raster images based on the pixel intensity counter; and
a display device configured to display the raster images.

2. The oscilloscope of claim 1, further including a memory module configured to store the digitized signal.

3. The oscilloscope of claim 1, the rasterizer further including an adder configured to increment the pixel intensity counter.

4. The oscilloscope of claim 3, further including a switching module configured to allow back and forth switching of the rasterizer between a first mode using the subtractor and a second mode using the adder.

5. The oscilloscope of claim 4, wherein the switching module includes a register.

6. The oscilloscope of claim 4, wherein the switching module resides inside the rasterizer.

7. A method for displaying a waveform in an oscilloscope, the method comprising:
acquiring input data corresponding to the waveform;
decrementing each of a plurality of pixel intensity counters based on a first rate of decay;
and
displaying the waveform based on the plurality of pixel intensity counters.

8. The method of claim 7, further comprising setting each of the pixel intensity counters to an initial pixel intensity value that is greater than zero and determined by 2^{N-1}, where N represents a number of bits in each pixel intensity counter.

9. The method of claim 8, wherein N has a value of 26.

10. The method of claim 8, further comprising resetting each of the pixel intensity counters to the initial value of 2^{N-1} responsive to the pixel intensity counters reaching a value of zero.

11. The method of claim 7, further comprising determining the first rate of decay based on a minimum pixel count and a maximum pixel count in at least one image of the waveform.

12. The method of claim 7, wherein the waveform is a frequently-occurring waveform or differs significantly from a frequently-occurring waveform.

13. The method of claim 7, wherein decrementing each of the pixel intensity counters is based on a second rate of decay or a third rate of decay.

14. A method for displaying a plurality of waveforms in an oscilloscope, the method comprising:
acquiring input data corresponding to a first waveform and a second waveform, wherein the first waveform is a frequently-occurring waveform and the second waveform is significantly different from the first waveform;
decrementing each of a plurality of pixel intensity counters based on a first rate of decay corresponding to the first waveform or a second rate of decay corresponding to the second waveform; and
displaying the first and second waveforms based at least in part on values of the plurality of pixel intensity counters.

15. The method of claim 14, further comprising:
setting the pixel intensity counters to initial pixel intensity values that are greater than zero and determined by 2^{N-1}, where N represents a number of bits in each pixel intensity counter; and/or
resetting each of the pixel intensity counters to the initial value of 2^{N-1} responsive to the pixel intensity counters reaching a value of zero; and/or
determining the first rate of decay corresponding to the first waveform and the second rate of decay corresponding to the second waveform based on a minimum pixel count and a maximum pixel count respectively, in a first image corresponding to the first waveform and in a second image corresponding to the second waveform.
